# EUROPEAN PATENT APPLICATION

(11) **EP 4 615 192 A1**
(43) Date of publication of application: **10.09.2025**
(21) Application number: 24853389.5
(22) Date of filing: 28.06.2024
(51) Int. Cl.: H10F 19/90, H10F 19/00

(54) **BACK-CONTACT BATTERY STRING GROUP AND PHOTOVOLTAIC MODULE**

(30) Priority: 17.08.2023 CN 202311043041
(71) Applicant: Longi Green Energy Technology Co., Ltd., Xi'an, Shaanxi 710100 (CN)
(72) Inventor: CHEN, Xiaoniu, Shaanxi 710100 (CN); ZHAO, Long, Shaanxi 710100 (CN); LI, Jie, Shaanxi 710100 (CN); LYU, Jun, Shaanxi 710100 (CN); FENG, Chunnuan, Shaanxi 710100 (CN); YU, Yonglin, Shaanxi 710100 (CN); ZHANG, Liang, Shaanxi 710100 (CN)
(74) Representative: Pfenning, Meinig & Partner mbB
(86) International application number: PCT/CN2024/102212
(87) International publication number: WO 2025/035974

(57) **Abstract**

The present application discloses a back contact solar cell string group and a photovoltaic module, and relates to the field of solar electricity generation technologies. The back contact solar cell string group includes at least two solar cell strings. Each of the at least two solar cell strings includes: multiple solar cells arranged along a second direction; and multiple welding strips, where any two adjacent solar cells in each of the at least two solar cell strings are electrically connected by corresponding welding strips of the multiple welding strips arranged along a first direction, and a distance between any two welding strips adjacent to each other along the first direction in each of the at least two solar cell strings is d1. In each of the at least two solar cell strings, welding strips adjacent to two edges of each of the multiple solar cells along the first direction are end welding strips. A distance between two end welding strips of two solar cell strings adjacent to each other in the at least two solar cell strings along the first direction is d2, 0.6 ≤ d2/d1 < 1. Therefore, a probability of uneven pressure borne by each of the multiple solar cells due to flowing of molten adhesive and an impact of the molten adhesive on each of the welding strips are reduced, to reduce an offset risk of a position of each of the welding strips. In addition, the two adjacent end welding strips can jointly distribute stress near the edge of each of the multiple solar cells, to reduce stress concentration and hidden cracking or fragmentation of each of the multiple solar cells.

## Description

### TECHNICAL FIELD

The present application relates to the field of solar electricity generation technologies, and in particular, to a back contact solar cell string group and a photovoltaic module.

### BACKGROUND

A photovoltaic module is a component structure formed by performing multiple processing steps, such as series welding, splicing, layering, and lamination, on multiple solar cells. During series welding, multiple solar cells are sequentially welded by welding strips, to form a solar cell string. However, there is a height difference between the welding strip and the multiple solar cells. During lamination, stress concentration easily occurs at edges of the multiple solar cells, causing hidden cracking or fragmentation of the multiple solar cells.

### SUMMARY

An objective of the present application is to provide a back contact solar cell string group and a photovoltaic module, so that a probability of uneven pressure borne by a solar cell due to flowing of molten adhesive and an impact of the molten adhesive on a welding strip are reduced, to further reduce an offset risk of a position of the welding strip. In addition, two adjacent end welding strips can jointly distribute stress near an edge of the solar cell, to further reduce stress concentration, so as to reduce hidden cracking or fragmentation of the solar cell.

To achieve the foregoing objectives, the following technical solutions are provided in the present application.

A back contact solar cell string group is provided, including at least two solar cell strings arranged along a first direction. Each of the at least two solar cell strings includes:
multiple solar cells arranged along a second direction; and
multiple welding strips, where the multiple welding strips extend along the second direction, the multiple welding strips being connected to the multiple solar cells, any two adjacent solar cells in each of the at least two solar cell strings being electrically connected by corresponding welding strips of the multiple welding strips arranged along the first direction, a distance between any two welding strips adjacent to each other along the first direction in each of the at least two solar cell strings being d1.

In each of the at least two solar cell strings, welding strips adjacent to two edges of each of the multiple solar cells along the first direction are end welding strips. A distance between two end welding strips of two solar cell strings adjacent to each other in the at least two solar cell strings along the first direction is d2. 0.6 ≤ d2/d1 < 1.

In the present application, a ratio of the distance d2 between the two end welding strips of the two solar cell strings adjacent to each other in the at least two solar cell strings along the first direction to the distance d1 between any two welding strips adjacent to each other along the first direction in each of the at least two solar cell strings is set within a proper range, that is, 0.6 ≤ d2/d1 < 1. Through such setting, the distance d2 between the two end welding strips of the two adjacent solar cell strings is properly less than the distance d1 between any two adjacent welding strips in each of the at least two solar cell strings, so that the distance d2 between the two end welding strips of the two adjacent solar cell strings is not excessively large, to reduce adhesive flowing between the two end welding strips of the two adjacent solar cell strings, and reduce a probability of uneven pressure borne by each of the multiple solar cells due to flowing of the molten adhesive. In addition, an impact of the molten adhesive on each of the welding strips is reduced, to reduce an offset risk of a position of each of the welding strips. In addition, the two adjacent end welding strips can jointly distribute stress near the edge of each of the multiple solar cells, to reduce stress concentration, so as to reduce hidden cracking or fragmentation of each of the multiple solar cells.

In the foregoing embodiment, a case in which the distance d2 between the two end welding strips of the two adjacent solar cell strings is excessively small is also avoided. In this way, a short circuit occurring when the two end welding strips of the two adjacent solar cell strings are excessively close to each other can be avoided.

In an embodiment, a distance between each of the end welding strips and a respective edge of each of the multiple solar cells along the first direction is d3. 0.2 ≤ d3/d2 ≤ 0.4. Through such setting, a proper distance between each of the end welding strips and the respective edge of each of the multiple solar cells is ensured. During lamination, the end welding strip can distribute stress near the edge of each of the multiple solar cells, to avoid stress concentration near the edge of each of the multiple solar cells, the stress concentration causing hidden cracking or fragmentation of each of the multiple solar cells. In addition, if the end welding strip of each of the multiple solar cells is excessively close to the edge of each of the multiple solar cells, a probability of hidden cracking at the edge of each of the multiple solar cells increases, and current collection efficiency is affected.

In an embodiment, d3 ranges from 1 mm to 6 mm. In this way, an excessively small distance between each of the end welding strips and the respective edge of each of the multiple solar cells can be avoided, a risk of a short circuit between the end welding strips of the adjacent solar cell strings is reduced, and stress concentration near the edge of each of the multiple solar cells is reduced, to reduce hidden cracking or fragmentation of each of the multiple solar cells. In addition/Alternatively, d1 ranges from 8 mm to 11 mm. Through such setting, the welding strips are arranged and spaced away based on a proper distance, and the multiple welding strips jointly distribute pressure during lamination, so that a risk of stress concentration in each of the multiple solar cells is further reduced.

In an embodiment, d2 ranges from 3 mm to 12 mm, so that both a proper string distance and a proper distance between each of the end welding strips and the respective edge of each of the multiple solar cells can be ensured. During lamination, a risk that the two adjacent solar cell strings overlap is avoided, and stress concentration near the edge of each of the multiple solar cells is reduced, to further reduce hidden cracking or fragmentation of each of the multiple solar cells. In addition/Alternatively, a string distance between the two solar cell strings adjacent to each other along the first direction is d4, and d4 ranges from 0.5 mm to 2.5 mm, so that a proper string distance between the adjacent solar cell strings is ensured, the risk that the two adjacent solar cell strings overlap is avoided during lamination can be avoided, and an excessively large string distance, causing an increase in an overall size of a photovoltaic module, between the two solar cell strings adjacent to each other along the first direction is avoided.

In an embodiment, two edges of a respective solar cell of the multiple solar cells along the second direction are a chamfered edge and a non-chamfered edge, respectively. The chamfered edge of the respective solar cell is adjacent to and is electrically connected to a chamfered edge of an adjacent solar cell by a welding strip, and the non-chamfered edge of the respective solar cell is adjacent to and is electrically connected to a non-chamfered edge of another adjacent solar cell by another welding strip. During arrangement of the solar cells, it is more convenient to align chamfered edges of adjacent solar cells, and it is more convenient to align non-chamfered edges of adjacent solar cells, so that a case in which it is difficult to align chamfered edges and non-chamfered edges of adjacent solar cells is avoided, and overall strength and aesthetic of the solar cell string are optimized.

In an embodiment, in each of the at least two solar cell strings, two solar cells whose non-chamfered edges are adjacent to each other are electrically connected by m welding strips, and m is an even number. Two solar cells whose chamfered edges are adjacent to each other are electrically connected by n welding strips, n is an odd number, and m - n = 1. In this solution, in multiple welding strips connected to a same solar cell, two end welding strips located on sides along the first direction may be located between two solar cells whose non-chamfered edges are adjacent to each other. When the distance d3 between each of the end welding strips and the respective edge of each of the multiple solar cells is designed, a problem that the end welding strip avoids a chamfered region does not need to be considered, so that the distance d3 between each of the end welding strips and the respective edge of each of the multiple solar cells is not limited by the chamfered region, to facilitate proper designing of the distance d3 between each of the end welding strips and the respective edge of each of the multiple solar cells.

In an embodiment, each of the end welding strips is located between the two solar cells whose non-chamfered edges are adjacent to each other, and an extension line of each of the end welding strips passes through chamfered regions of the multiple solar cells. In this way, a larger quantity of welding strips may be disposed, to reduce stress concentration near the edge of each of the multiple solar cells, and further reduce hidden cracking or fragmentation of each of the multiple solar cells. In addition, each of the end welding strips does not overlap the chamfered regions of the multiple solar cells, to avoid uneven stress caused by suspension of each of the end welding strips in the chamfered regions, and avoid hidden cracking or fragmentation at the edge of each of the multiple solar cells that may be caused during lamination.

In an embodiment, along the second direction, a distance between two solar cells whose chamfered edges are adjacent to each other is greater than a distance between two solar cells whose non-chamfered edges are adjacent to each other. In this way, a distance between the adjacent chamfered edges of the two solar cells is large. During lamination, the chamfered edges of the adjacent two solar cells approach each other after being deformed, and do not easily contact or overlap, to avoid cell combination and reduce a risk of cell combination of the solar cells.

In an embodiment, along the second direction, the distance between the two solar cells whose chamfered edges are adjacent to each other ranges from 0.3 mm to 1.3 mm; and/or the distance between the two solar cells whose non-chamfered edges are adjacent to each other ranges from 0.1 mm to 1.1 mm, so that the risk of cell combination of the solar cells is reduced, an excessively large overall length of the solar cell string is avoided, and stability of connection between the adjacent solar cells is improved.

In an embodiment, a first polarity connection portion of a respective solar cell of the multiple solar cells is electrically connected to a second polarity connection portion of an adjacent solar cell by a welding strip, and a second polarity connection portion of the respective solar cell of the multiple solar cells is electrically connected to a first polarity connection portion of another adjacent solar cell by another welding strip. The welding strip connected to the first polarity connection portion of the respective solar cell and the welding strip connected to the second polarity connection portion of the respective solar cell are alternately arranged and spaced away along the first direction. The first polarity connection portion and the second polarity connection portion have opposite polarities. In this way, current collection efficiency can be improved, currents inside the solar cell are more uniform, and a current loss inside the solar cell is reduced.

In an embodiment, the first polarity connection portion and the second polarity connection portion are a P-type doped layer and an N-type doped layer of the respective solar cell, respectively. For a solar cell without a grid or a solar cell without a main grid, the welding strip may be directly electrically connected to a P-type doped layer and an N-type doped layer of the solar cell, to electrically connect adjacent solar cells. Component power is increased by reducing blocking and a resistance loss, and processing costs are reduced.

In an embodiment, the first polarity connection portion and the second polarity connection portion are a positive gate electrode and a negative gate electrode of the respective solar cell.

A photovoltaic module is provided, including at least one back contact solar cell string group. Each of the at least one back contact solar cell string group is the back contact solar cell string group in any one of the foregoing embodiments.

In comparison with the prior art, beneficial effects of the photovoltaic module provided in the above embodiments of the present application are the same as those of the foregoing back contact solar cell string group, and details are not described herein again.

### BRIEF DESCRIPTION OF THE DRAWINGS

The accompanying drawings described herein are used for providing further understanding for the present application and constitute a part of the present application. Example embodiments of the present application and descriptions thereof are used for explaining the present application and do not constitute an improper limitation to the present application. In the accompanying drawings:
FIG. 1 is a schematic diagram of a solar cell string and welding strips according to an embodiment of the present application; and
FIG. 2 is a local schematic diagram of solar cell strings adjacent to each other along a first direction according to an embodiment of the present application.

### Reference numerals:

1: solar cell; 1a: non-chamfered edge; 1b: chamfered edge; 2: welding strip; and 2a: end welding strip.

### DETAILED DESCRIPTION

To make to-be-resolved technical problems, technical solutions, and beneficial effects of the present application clearer and more comprehensible, the following further describes the present application in detail with reference to the accompanying drawings and embodiments. It should be understood that the specific embodiments described herein are merely used for explaining the present application rather than limiting the present application.

It should be noted that, when an element is referred to as being "fixed to" or "arranged on" another element, the element may be directly on the another element or indirectly on the another element. When an element is referred to as being "connected to" another element, the element may be directly connected to the another element or indirectly connected to the another element.

In addition, the terms "first" and "second" are merely intended for a purpose of description, and shall not be understood as indicating or implying relative significance or implicitly indicating a quantity of indicated technical features. Therefore, features defining "first" and "second" can explicitly or implicitly include one or more of the features. In the descriptions of the present application, unless clearly and specifically defined otherwise, "multiple" means two or more than two. Unless clearly and specifically defined otherwise, "a plurality of" means two or more than two.

It needs to be understood that, in the descriptions of the present application, a direction or positional relationship indicated by terms such as "up", "down", "front", "back", "left", and "right" is a direction or positional relationship based on illustrations in the drawings, and is merely intended for ease or brevity of description of the present application, but does not necessarily mean or imply that the indicated device or component is provided in the specified direction or constructed or operated in the specified direction. Therefore, such terms are not to be understood as a limitation on the present application.

In the descriptions of the present application, it should be noted that, unless otherwise clearly specified and defined, terms such as "mounting", "mutual connection", and "connection" shall be understood in a broad sense, for example, may be a fixing connection, a detachable connection, an integral connection, a mechanical connection, an electrical connection, a direct connection, an indirect connection by using an intermediate medium, communication between interiors of two components, and interaction between two components. A person of ordinary skill in the art may understand specific meanings of the terms in the present application according to specific situations.

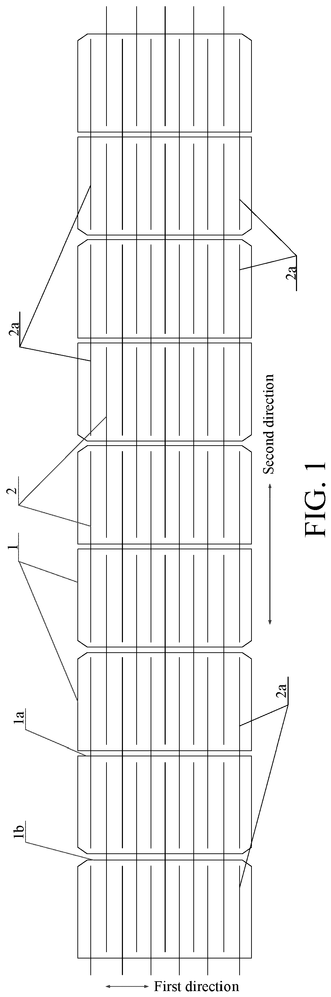

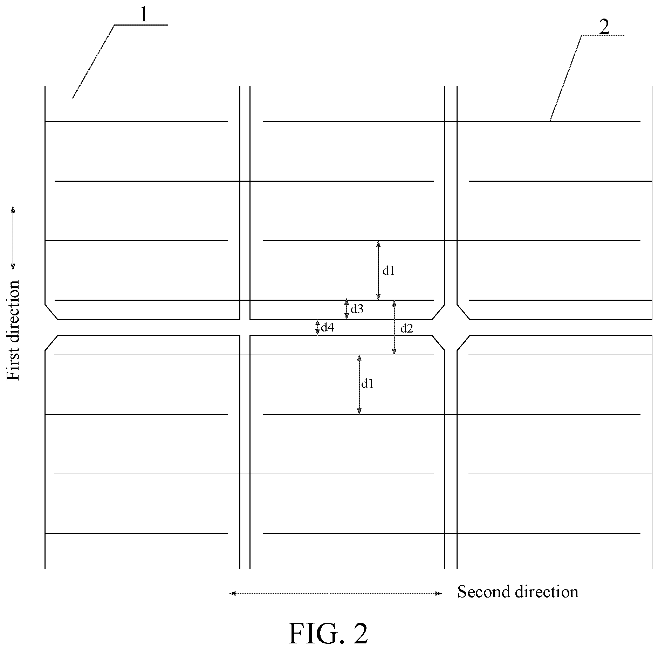

As shown in FIG. 1 and FIG. 2, a back contact solar cell string group (which is referred to as a solar cell string group for short below) provided in the present application includes at least two solar cell strings arranged along a first direction. To be specific, the solar cell string group includes two or more solar cell strings, the multiple solar cell strings in the solar cell string group are arranged along the first direction, and the multiple solar cell strings in the solar cell string group are connected in series or parallel.

Any one of the solar cell strings includes multiple solar cells 1 and multiple welding strips 2. In each of the at least two solar cell strings, there are two or more solar cells 1, and the multiple solar cells 1 in the solar cell string are arranged along a second direction. The multiple welding strips 2 extend along the second direction, in other words, a length direction of the multiple welding strips 2 extends along the second direction.

The multiple welding strips 2 are connected to the multiple solar cells 1, and any two adjacent solar cells 1 in each of the at least two solar cell strings are electrically connected by corresponding welding strips of the multiple welding strips 2 arranged along the first direction. Specifically, the multiple welding strips 2 arranged along the first direction connects any two adjacent solar cells 1 in each of the at least two solar cell strings in series. The multiple welding strips 2 between the two adjacent solar cells 1 are arranged along the first direction, one end of each of the welding strips 2 is connected to one of the solar cells 1, and the other end of the welding strip 2 is connected to the other of the solar cells 1.

A distance between any two welding strips 2 adjacent to each other along the first direction in each of the at least two solar cell strings is d1. To be specific, in multiple welding strips 2 connected to a same solar cell 1, a distance between two welding strips 2 adjacent to each other along the first direction is d1. Specifically, a distance between edges that are of any two adjacent welding strips 2 and that are close to each other is d1.

In each of the at least two solar cell strings, welding strips 2 adjacent to two edges of each of the multiple solar cells 1 along the first direction are end welding strips 2a. To be specific, in multiple welding strips 2 connected to a same solar cell 1, welding strips 2 that are closest to two edges of the solar cell 1 along the first direction are the end welding strips 2a. A distance between two end welding strips 2a of two solar cell strings adjacent to each other in the at least two solar cell strings along the first direction is d2. Specifically, along the first direction, a distance between edges that are of the two end welding strips 2a of the two adjacent solar cell strings and that are close to each other is d2, and 0.6 ≤ d2/d1 < 1.

During lamination, an adhesive film layer of a photovoltaic module is heated and molten, and molten adhesive has flowability. If the distance d2 between the two end welding strips 2a of the two solar cell strings adjacent to each other in the at least two solar cell strings along the first direction is large, the molten adhesive easily flows between the two end welding strips 2a of the two adjacent solar cell strings and flows to a gap between the two adjacent solar cell strings. After flowing, the molten adhesive is unevenly distributed, resulting in uneven pressure borne by the solar cell 1, and easily causing hidden cracking or fragmentation of the solar cell 1. In addition, during flowing of the molten adhesive, the molten adhesive easily impacts the welding strip 2, causing a position offset of the welding strip 2.

In addition, the welding strip 2 has a height. Usually, a cross section of the welding strip 2 is circular, and a diameter of the welding strip 2 is approximately 0.25 mm. After the welding strip 2 is connected to the solar cell 1, there is a height difference between the welding strip 2 and a surface of the solar cell 1. During lamination, stress concentration easily occurs near a position at which the solar cell 1 is connected to the welding strip 2, causing hidden cracking or fragmentation of the solar cell 1. An applicant discovers, by researching lamination of the photovoltaic module, that, when a quantity of the welding strips 2 is larger and a distance between the welding strips 2 is smaller, pressure borne by the solar cell 1 during lamination is more even, and stress is more easily distributed. Conversely, when the quantity of the welding strips 2 is smaller and the distance between the welding strips 2 is larger, stress concentration more easily occurs in the solar cell 1 during lamination, and hidden cracking or fragmentation occurs. It can be learned from the foregoing descriptions that, if the distance d2 between the two end welding strips 2a of the two solar cell strings adjacent to each other in the at least two solar cell strings along the first direction is excessively large, not only the molten adhesive easily flows between the two end welding strips 2a of the two adjacent solar cell strings, causing uneven pressure borne by the solar cell 1, but also a distance between welding strips 2 near the edge of the solar cell 1 is large, and stress is not easily distributed, easily causing hidden cracking or fragmentation.

Based on the foregoing situation, in this embodiment of the present application, a ratio of the distance d2 between the two end welding strips 2a of the two solar cell strings adjacent to each other in the at least two solar cell strings along the first direction to the distance d1 between any two welding strips 2 adjacent to each other along the first direction in each of the at least two solar cell strings is set within a proper range, that is, 0.6 ≤ d2/d1 < 1. Through such setting, the distance d2 between the two end welding strips 2a of the two adjacent solar cell strings is properly less than the distance d1 between any two adjacent welding strips 2 in each of the at least two solar cell strings, so that the distance d2 between the two end welding strips 2a of the two adjacent solar cell strings is not excessively large (that is, a value of d2/d1 is greater than 1), to reduce adhesive flowing between the two end welding strips 2a of the two adjacent solar cell strings, and reduce a probability of uneven pressure borne by each of the multiple solar cells 1 due to flowing of the molten adhesive. In addition, an impact of the molten adhesive on each of the welding strips 2 is reduced, to reduce an offset risk of a position of each of the welding strips 2. In addition, the two adjacent end welding strips 2a can jointly distribute stress near the edge of each of the multiple solar cells 1, to reduce stress concentration, so as to reduce hidden cracking or fragmentation of each of the multiple solar cells 1. In addition, if the end welding strip of each of the multiple solar cells is excessively close to the edge of each of the multiple solar cells, a probability of hidden cracking at the edge of each of the multiple solar cells increases, and current collection efficiency is affected. For example, the ratio of the distance d2 between the two end welding strips 2a of the two solar cell strings adjacent to each other in the at least two solar cell strings along the first direction to the distance d1 between any two welding strips 2 adjacent to each other along the first direction in each of the at least two solar cell strings may be 0.6, 0.8, or 1.

In the foregoing embodiment, a case in which the distance d2 between the two end welding strips 2a of the two adjacent solar cell strings is excessively small (that is, the value of d2/d1 is less than 0.6) is also avoided. In this way, a short circuit occurring when the two end welding strips 2a of the two adjacent solar cell strings are excessively close to each other can be avoided.

As shown in FIG. 2, a distance between each of the end welding strips 2a and a respective edge of each of the multiple solar cells 1 along the first direction is d3. Specifically, along the first direction, a distance between the respective edge of each of the multiple solar cells 1 and an edge that is of each of the end welding strips 2a and that is close to a side of the respective edge of each of the multiple solar cells 1 is d3, and 0.2 ≤ d3/d2 ≤ 0.4. Through such setting, a proper distance between each of the end welding strips 2a and the respective edge of each of the multiple solar cells 1 is ensured. During lamination, the end welding strip 2a can distribute stress near the respective edge of each of the multiple solar cells 1, to avoid stress concentration near the respective edge of each of the multiple solar cells 1, the stress concentration causing hidden cracking or fragmentation of each of the multiple solar cells 1. For example, d3/d2 may be 0.2, 0.25, 0.3, 0.35, 0.4, 0.45, 0.5, 0.55, or 0.6.

In a specific implementation, the distance d3 between each of the end welding strips 2a and the respective edge of each of the multiple solar cells 1 along the first direction ranges from 1 mm to 6 mm. When the distance d3 between each of the end welding strips 2a and the respective edge of each of the multiple solar cells 1 is less than 1 mm, a distance between end welding strips 2a of adjacent solar cell strings is small, and a short circuit easily occurs. When the distance d3 between each of the end welding strips 2a and the respective edge of each of the multiple solar cells 1 is greater than 6 mm, stress concentration is easily caused near the edge of each of the multiple solar cells 1. Therefore, when the distance d3 between each of the end welding strips 2a and the respective edge of each of the multiple solar cells 1 ranges from 1 mm to 6 mm, an excessively small distance between each of the end welding strips 2a and the respective edge of each of the multiple solar cells 1 can be avoided, a risk of a short circuit between the end welding strips 2a of the adjacent solar cell strings is reduced, and stress concentration near the edge of each of the multiple solar cells 1 is reduced, to reduce hidden cracking or fragmentation of each of the multiple solar cells 1. For example, the distance d3 between each of the end welding strips 2a and the respective edge of each of the multiple solar cells 1 may be 1 mm, 1.5 mm, 2 mm, 2.5 mm, 3 mm, 3.5 mm, 4 mm, 4.5 mm, 5 mm, 5.5 mm, or 6 mm.

In addition, the distance d1 between any two welding strips 2 adjacent to each other along the first direction ranges from 8 mm to 11 mm. To be specific, in multiple welding strips 2 connected to a same solar cell 1, a distance between any two welding strips 2 adjacent to each other along the first direction ranges from 8 mm to 11 mm. Through such setting, the welding strips 2 are arranged and spaced away based on a proper distance, and the multiple welding strips 2 jointly distribute pressure during lamination, so that a risk of stress concentration in each of the multiple solar cells 1 is further reduced. For example, the distance d1 between any two welding strips 2 adjacent to each other along the first direction is 8 mm, 8.5 mm, 9 mm, 9.5 mm, 10 mm, 10.5 mm, or 11 mm.

Preferably, the distance d2 between the two end welding strips 2a of the two solar cell strings adjacent to each other in the at least two solar cell strings along the first direction ranges from 3 mm to 12 mm. Because the distance d2 between the two end welding strips 2a of the two adjacent solar cell strings includes the distance d3 between each of the end welding strips 2a and the respective edge of each of the multiple solar cells 1 and a string distance d4 between the two solar cell strings adjacent to each other along the first direction, the distance d2 between the two end welding strips 2a of the two adjacent solar cell strings ranges from 3 mm to 12 mm, so that both a proper string distance and a proper distance between each of the end welding strips 2a and the respective edge of each of the multiple solar cells 1 can be ensured. During lamination, a risk that the two adjacent solar cell strings overlap is avoided, and stress concentration near the edge of each of the multiple solar cells 1 is reduced, to further reduce hidden cracking or fragmentation of each of the multiple solar cells 1. For example, the distance d2 between the two end welding strips 2a of the two solar cell strings adjacent to each other in the at least two solar cell strings along the first direction may be 3 mm, 4 mm, 5 mm, 6 mm, 7 mm, 8 mm, 9 mm, 10 mm, 11 mm, or 12 mm, and preferably ranges from 7 mm to 10 mm.

In addition, the string distance between the two solar cell strings adjacent to each other along the first direction is d4. To be specific, along the first direction, a distance between one of the adjacent solar cell strings and an edge of a solar cell 1 of the other solar cell string is d4, and d4 ranges from 0.5 mm to 2.5 mm. When the string distance d4 between the two solar cell strings adjacent to each other along the first direction is less than 0.5 mm, the string distance between the adjacent solar cell strings is small, and the two adjacent solar cell strings easily overlap during lamination. When the string distance d4 between the two solar cell strings adjacent to each other along the first direction is greater than 2.5 mm, the string distance between the two adjacent solar cell strings is excessively large, causing an increase in an overall size of the photovoltaic module. Therefore, the string distance d4 between the two solar cell strings adjacent to each other along the first direction is set to the range from 0.5 mm to 2.5 mm, so that a proper string distance between the adjacent solar cell strings is ensured, the risk that the two adjacent solar cell strings overlap is avoided during lamination can be avoided, and an excessively large string distance, causing an increase in the overall size of the photovoltaic module, between the two solar cell strings adjacent to each other along the first direction is avoided. For example, the string distance d4 between the two solar cell strings adjacent to each other along the first direction may be 0.5 mm, 0.8 mm, 1 mm, 1.2 mm, 1.5 mm, 1.8 mm, 2 mm, 2.2 mm, or 2.5 mm. Certainly, the string distance d4 between the two adjacent solar cell strings may alternatively be slightly greater than 2.5 mm based on an actual situation, and is not limited herein.

The solar cell 1 is usually formed by cutting a monocrystalline silicon ingot into blocks. Because the monocrystalline silicon ingot is usually cylindrical, to increase a lighting area to the greatest extent and save a material of the silicon ingot, the solar cell 1 formed by cutting the monocrystalline silicon ingot into blocks usually has a rounded corner. To achieve objectives such as a smoother corner of the solar cell 1 and lower corner stress, further processing and machining need to be performed on the rounded corner, so that the solar cell 1 has four smooth chamfers. In addition, to enable the solar cell 1 to have different specifications and be used in different environments, the solar cell 1 may be further cut, and is divided into multiple small-format solar cells 1. One side of the solar cell 1 obtained through cutting is a chamfered edge 1b having a chamfer, and the other side of the cut solar cell 1 is a non-chamfered edge 1a having no chamfer.

In this embodiment, two edges of a respective solar cell of the multiple solar cells 1 along the second direction are a chamfered edge 1b and a non-chamfered edge 1a, respectively. To be specific, two edges of the solar cell 1 that are opposite to each other along the second direction, rather than edges that are of the solar cell 1 and that are parallel to the first direction, are respectively the chamfered edge 1b and the non-chamfered edge 1a. Specifically, two ends of an edge of the solar cell 1 along the first direction each have a chamfer, and the edge of the solar cell 1 is the chamfered edge 1b. The other edge of the solar cell 1 is a straight edge along the first direction, and the edge of the solar cell 1 is the non-chamfered edge 1a.

The chamfered edge 1b of the respective solar cell 1 is adjacent to and is electrically connected to a chamfered edge 1b of an adjacent solar cell 1 by a welding strip 2. The non-chamfered edge 1a of the respective solar cell 1 is adjacent to and is electrically connected to a non-chamfered edge 1a of another adjacent solar cell 1 by another welding strip 2. Specifically, in each of the at least two solar cell strings, chamfered edges 1b of adjacent solar cells 1 are adjacent, and non-chamfered edges 1a of adjacent solar cells 1 in the solar cell string are adjacent. In the solar cell string, if three solar cells 1 sequentially arranged along the second direction are a first solar cell, a second solar cell, and a third solar cell, a chamfered edge 1b of the first solar cell is adjacent to a chamfered edge 1b of the second solar cell, and a non-chamfered edge 1a of the second solar cell is adjacent to a non-chamfered edge 1a of the third solar cell. Through such setting, during arrangement of the solar cells 1, it is more convenient to align chamfered edges 1b of adjacent solar cells 1, and it is more convenient to align non-chamfered edges 1a of adjacent solar cells 1, so that a case in which it is difficult to align chamfered edges 1b and non-chamfered edges 1a of adjacent solar cells 1 is avoided, and overall strength and aesthetic of the solar cell string are optimized. Certainly, in the solar cell string, the chamfered edge 1b of the respective solar cell 1 may alternatively be adjacent to a non-chamfered edge 1a of an adjacent solar cell 1, and the non-chamfered edge 1a of the respective solar cell 1 is adjacent to a chamfered edge 1b of another adjacent solar cell 1. This is not limited herein.

Further, in each of the at least two solar cell strings, two solar cells 1 whose non-chamfered edges 1a are adjacent to each other are electrically connected by m welding strips 2, and m is an even number. Two solar cells 1 whose chamfered edges 1b are adjacent to each other are electrically connected by n welding strips 2, n is an odd number, and m - n = 1. For example, m may be 10, and n may be 9. To be specific, a quantity of welding strips 2 connected to each of the multiple solar cells 1 is 19. Each of the multiple solar cells 1 is electrically connected, by using ten welding strips 2, to a solar cell 1 whose non-chamfered edge 1a is adjacent to a non-chamfered edge 1a of each of the multiple solar cells 1, and is electrically connected, by using nine welding strips 2, to another solar cell 1 whose chamfered edge 1b is adjacent to a chamfered edge 1b of each of the multiple solar cells 1. Certainly, m and n may alternatively be other values. For example, m is 8, and n may be 7. A person skilled in the art may set the values based on an actual situation. The two solar cells 1 whose non-chamfered edges 1a are adjacent to each other are electrically connected by m + n welding strips 2, in other words, the two solar cells 1 whose non-chamfered edges 1a are adjacent to each other are electrically connected by an odd number of welding strips 2 In this embodiment, in multiple welding strips 2 connected to a same solar cell 1, two end welding strips 2a located on sides along the first direction may be located between two solar cells 1 whose non-chamfered edges 1a are adjacent to each other. When the distance d3 between each of the end welding strips 2a and the respective edge of each of the multiple solar cells 1 is designed, a problem that the end welding strip 2a avoids a chamfered region does not need to be considered, so that the distance d3 between each of the end welding strips 2a and the respective edge of each of the multiple solar cells 1 is not limited by the chamfered region, to facilitate proper designing of the distance d3 between each of the end welding strips 2a and the respective edge of each of the multiple solar cells 1.

Preferably, each of the end welding strips 2a is located between the two solar cells 1 whose non-chamfered edges 1a are adjacent to each other. In other words, each of the end welding strips 2a is configured to electrically connect the two solar cells 1 whose non-chamfered edges 1a are adjacent to each other. In this way, each of the end welding strips 2a does not need to avoid the chamfered region. Each of the end welding strips 2a may be closer to the respective edge of each of the multiple solar cells 1 along the second direction, and an extension line of each of the end welding strips 2a even passes through chamfered regions of the multiple solar cells 1. In this way, a larger quantity of welding strips may be disposed, to reduce stress concentration near the edge of each of the multiple solar cells 1, and further reduce hidden cracking or fragmentation of each of the multiple solar cells 1. In addition, each of the end welding strips 2a does not overlap the chamfered regions of the multiple solar cells 1, to avoid uneven stress caused by suspension of each of the end welding strips 2a in the chamfered regions, and avoid hidden cracking or fragmentation at the edge of each of the multiple solar cells 1 that may be caused during lamination. It should be noted that, in this embodiment, the two solar cells 1 whose chamfered edges 1b are adjacent to each other are electrically connected only by remaining welding strips 2 located between the two end welding strips 2a, and the remaining welding strips 2 located between the two end welding strips 2a are far from the respective edge of each of the multiple solar cells 1, so that the welding strips 2 between the two solar cells 1 whose chamfered edges 1b are adjacent to each other avoid the chamfered regions and do not overlap the chamfered regions.

Certainly, based on an actual situation, the two solar cells 1 whose non-chamfered edges 1a are adjacent to each other may alternatively be electrically connected by an odd number of welding strips 2, and the two solar cells 1 whose chamfered edges 1b are adjacent to each other are electrically connected by an even number of welding strips 2. In this case, each of the end welding strips 2a is located between the two solar cells 1 whose non-chamfered edges 1a are adjacent to each other, and the end welding strip 2a may pass through the chamfered regions of the multiple solar cells 1. Alternatively, a small quantity of end welding strips 2a are disposed to avoid the chamfered regions of the multiple solar cells 1.

It can be learned from the foregoing descriptions that, in the solar cell string, when a quantity of welding strips 2 between the two solar cells 1 whose chamfered edges 1b are adjacent to each other is an odd number, and a quantity of welding strips 2 between the two solar cells 1 whose non-chamfered edges 1a are adjacent to each other is an even number, disposing of denser polarity connection portions is facilitated, thereby facilitating faster export of electrons, improving electricity generation efficiency, avoiding uneven stress caused when the welding strip 2 passes through the chamfered region, avoiding fragmentation or hidden cracking of the solar cell 1, and improving a yield rate of the photovoltaic module.

Usually, in the solar cell string, the multiple solar cells 1 are welded by using an equal-distance arrangement structure. When a distance between any two of adjacent solar cells 1 is equal, overall series welding may be more convenient. However, the edge of the solar cell 1 is warped after series welding. During lamination, the solar cell 1 is flattened by a force, and edges of the two adjacent solar cells 1 approach each other after being pressed and deformed. Consequently, the distance between the two adjacent solar cells 1 becomes smaller, and cell combination easily occurs. In particular, cell combination of two solar cells 1 whose chamfered edges 1b are adjacent to each other is severer.

Based on the foregoing situation, in this embodiment, along the second direction, a distance between two solar cells 1 whose chamfered edges 1b are adjacent to each other is greater than a distance between two solar cells 1 whose non-chamfered edges 1a are adjacent to each other. The distance between the two solar cells 1 whose chamfered edges 1b are adjacent to each other is specifically a distance between the chamfered edges 1b of the two adjacent solar cells 1, and the distance between the two solar cells 1 whose non-chamfered edges 1a are adjacent to each other is specifically a distance between the non-chamfered edges 1a of the two adjacent solar cells 1. Because a quantity of welding strips 2 disposed between the chamfered edges 1b of the adjacent solar cells 1 is small, stability of connection between the two chamfered edges 1b of the adjacent solar cells 1 is poor, and deformation and offset easily occur. When the distance between the two solar cells 1 whose chamfered edges 1b are adjacent to each other is greater than the distance between the two solar cells 1 whose non-chamfered edges 1a are adjacent to each other, a distance between the adjacent chamfered edges 1b of the two solar cells 1 is large. During lamination, the chamfered edges 1b of the two adjacent solar cells 1 approach each other after being deformed, and do not easily contact or overlap, to avoid cell combination and reduce a risk of cell combination of the solar cells 1.

Further, along the second direction, the distance between the two solar cells 1 whose chamfered edges 1b are adjacent to each other ranges from 0.3 mm to 1.3 mm. When the distance between the two solar cells 1 whose chamfered edges 1b are adjacent to each other is less than 0.3 mm, the distance between the chamfered edges 1b of the two adjacent solar cells 1 is small, and cell combination easily occurs. When the distance between the two solar cells 1 whose chamfered edges 1b are adjacent to each other is greater than 1.3 mm, the distance between the chamfered edges 1b of the two adjacent solar cells 1 is large. Consequently, an overall length of the solar cell string increases, and stability of connection between adjacent solar cells 1 is reduced. Therefore, the distance between the two solar cells 1 whose chamfered edges 1b are adjacent to each other is set to 0.3 mm to 1.3 mm, so that an excessively large overall length of the solar cell string is avoided, and the stability of the connection between the adjacent solar cells 1 is improved while a risk of cell combination of the solar cells 1 is reduced. For example, the distance between the two solar cells 1 whose chamfered edges 1b are adjacent to each other is 0.3 mm, 0.4 mm, 0.5 mm, 0.6 mm, 0.7 mm, 0.8 mm, 0.9 mm, 1.0 mm, 1.1 mm, 1.2 mm, or 1.3 mm.

In addition, along the second direction, the distance between the two solar cells 1 whose non-chamfered edges 1a are adjacent to each other ranges from 0.1 mm to 1.1 mm. When the distance between the two solar cells 1 whose non-chamfered edges 1a are adjacent to each other is less than 0.1 mm, the distance between the non-chamfered edges 1a of the two adjacent solar cells 1 is small, and cell combination easily occurs. When the distance between the two solar cells 1 whose non-chamfered edges 1a are adjacent to each other is greater than 1.1 mm, the distance between the non-chamfered edges 1a of the adjacent solar cells 1 is large. Consequently, an overall length of the solar cell string increases, and stability of connection between adjacent solar cells 1 is reduced. Therefore, the distance between the two solar cells 1 whose non-chamfered edges 1a are adjacent to each other is set to 0.1 mm to 1.1 mm, so that an excessively large overall length of the solar cell string is avoided, and the stability of the connection between the adjacent solar cells 1 is improved while a risk of cell combination of the solar cells 1 is reduced. Specifically, the distance between the two solar cells 1 whose non-chamfered edges 1a are adjacent to each other may be 0.1 mm, 0.2 mm, 0.3 mm, 0.4 mm, 0.5 mm, 0.6 mm, 0.7 mm, 0.8 mm, 0.9 mm, 1.0 mm, 1.1 mm, or the like.

Preferably, along the second direction, the distance between the two solar cells 1 whose chamfered edges 1b are adjacent to each other ranges from 0.3 mm to 1.3 mm, and the distance between the two solar cells 1 whose non-chamfered edges 1a are adjacent to each other ranges from 0.1 mm to 1.1 mm. For example, when the distance between the two solar cells 1 whose chamfered edges 1b are adjacent to each other is 0.3 mm, the distance between the two solar cells 1 whose non-chamfered edges 1a are adjacent to each other ranges from 0.1 mm to 0.2 mm. When the distance between the two solar cells 1 whose non-chamfered edges 1a are adjacent to each other is 1.1 mm, the distance between the two solar cells 1 whose chamfered edges 1b are adjacent to each other ranges from 1.2 mm to 1.3 mm. When the distance between the two solar cells 1 whose chamfered edges 1b are adjacent to each other is 0.6 mm, the distance between the two solar cells 1 whose non-chamfered edges 1a are adjacent to each other is 0.5 mm; when the distance between the two solar cells 1 whose chamfered edges 1b are adjacent to each other is 0.9 mm, the distance between the two solar cells 1 whose non-chamfered edges 1a are adjacent to each other is 0.7 mm, and so on. A person skilled in the art may set, based on an actual situation, the distance between the two solar cells 1 whose chamfered edges 1b are adjacent to each other and the distance between the two solar cells 1 whose non-chamfered edges 1a are adjacent to each other.

In the foregoing embodiments, a first polarity connection portion of a respective solar cell of the multiple solar cells 1 is electrically connected to a second polarity connection portion of an adjacent solar cell 1 by a welding strip 2, and a second polarity connection portion of the respective solar cell 1 is electrically connected to a first polarity connection portion of another adjacent solar cell 1 by another welding strip 2. The first polarity connection portion and the second polarity connection portion have opposite polarities. Specifically, in the solar cell string, if three solar cells 1 sequentially arranged along the second direction are a first solar cell, a second solar cell, and a third solar cell, a first polarity connection portion of the second solar cell is electrically connected to a second polarity connection portion of the first solar cell by a welding strip 2, and a second polarity connection portion of the second solar cell is electrically connected to a first polarity connection portion of the third solar cell by a welding strip 2, so that the first solar cell, the second solar cell, and the third solar cell are connected in series.

Further, the welding strip 2 connected to the first polarity connection portion of the respective solar cell 1 and the welding strip 2 connected to the second polarity connection portion of the respective solar cell 1 are alternately arranged and spaced away along the first direction, and the first polarity connection portion and the second polarity connection portion in the solar cell 1 may be alternately arranged and spaced away along the first direction. In other words, in the respective solar cell 1, a second polarity connection portion is disposed between two first polarity connection portions adjacent to each other along the first direction, and a first polarity connection portion is disposed between two second polarity connection portions adjacent to each other along the first direction. Because the welding strip 2 is connected to the first polarity connection portion or the second polarity connection portion, the welding strip 2 connected to the first polarity connection portion of the solar cell 1 and the welding strip 2 connected to the second polarity connection portion of the same solar cell 1 are also adaptively arranged and spaced away along the first direction alternately. In this way, current collection efficiency can be improved, currents inside the solar cell 1 are more uniform, and a current loss inside the solar cell is reduced.

In a specific embodiment, the first polarity connection portion and the second polarity connection portion are a P-type doped layer and an N-type doped layer of the respective solar cell 1, respectively. Specifically, the first polarity connection portion is a P-type doped layer, and the second polarity connection portion is an N-type doped layer. Alternatively, the first polarity connection portion is an N-type doped layer, and the second polarity connection portion is a P-type doped layer. For a solar cell 1 without a grid or a solar cell 1 without a main grid, the welding strip may be directly electrically connected to a P-type doped layer and an N-type doped layer of the solar cell 1, to electrically connect adjacent solar cells 1. Component power is increased by reducing blocking and a resistance loss, and processing costs are reduced.

In another specific embodiment, the first polarity connection portion and the second polarity connection portion are a positive gate electrode and a negative gate electrode of the respective solar cell 1. Specifically, the first polarity connection portion is a positive gate electrode, and the second polarity connection portion is a negative gate electrode. Alternatively, the first polarity connection portion is a negative gate electrode, and the second polarity connection portion is a positive gate electrode. Multiple positive gate electrodes and negative gate electrodes alternately arranged and spaced away along the first direction are disposed on the solar cell 1, the positive gate electrodes and the negative gate electrodes extend along the second direction, and the welding strips 2 are connected to the positive gate electrodes or the negative gate electrodes, to electrically connect adjacent solar cells 1.

An embodiment of the present application further provides a photovoltaic module. The photovoltaic module includes at least one back contact solar cell string group, and each of the at least one back contact solar cell string group is the back contact solar cell string group provided in any one of the foregoing embodiments. When the photovoltaic module includes multiple back contact solar cell string groups, the multiple back contact solar cell string groups may be arranged along a second direction, and the multiple back contact solar cell string groups may be connected in parallel.

In comparison with the prior art, beneficial effects of the photovoltaic module provided in the above embodiments of the present application are the same as those of the foregoing back contact solar cell string group, and details are not described herein again.

In the descriptions of the foregoing implementations, the specific feature, structure, material, or characteristic described may be combined in an appropriate manner in any one or more embodiments or examples.

The foregoing descriptions are merely specific implementations of the present application, but are not intended to limit the protection scope of the present application. Any variation or replacement readily figured out by a person skilled in the art within the technical scope disclosed in the present application shall fall within the protection scope of the present application. Therefore, the protection scope of the present application shall be subject to the protection scope of the claims.

## Claims

1. Aback contact solar cell string group, comprising at least two solar cell strings arranged along a first direction, wherein each of the at least two solar cell strings comprises:
a plurality of solar cells arranged along a second direction; and
a plurality of welding strips, wherein the plurality of welding strips extend along the second direction, the plurality of welding strips being connected to the plurality of solar cells, any two adjacent solar cells in each of the at least two solar cell strings being electrically connected by corresponding welding strips of the plurality of welding strips arranged along the first direction, a distance between any two welding strips adjacent to each other along the first direction in each of the at least two solar cell strings being d1,
wherein in each of the at least two solar cell strings, welding strips adjacent to two edges of each of the plurality of solar cells along the first direction are end welding strips;
wherein a distance between two end welding strips of two solar cell strings adjacent to each other in the at least two solar cell strings along the first direction is d2, 0.6 ≤ d2/d1 < 1.

2. The back contact solar cell string group according to claim 1, wherein a distance between each of the end welding strips and a respective edge of each of the plurality of solar cells along the first direction is d3, 0.2 ≤ d3/d2 ≤ 0.4.

3. The back contact solar cell string group according to claim 2, wherein d3 ranges from 1 mm to 6 mm; and/or d1 ranges from 8 mm to 11 mm.

4. The back contact solar cell string group according to claim 1, wherein d2 ranges from 3 mm to 12 mm; and/or a string distance between the two solar cell strings adjacent to each other along the first direction is d4, d4 ranging from 0.5 mm to 2.5 mm.

5. The back contact solar cell string group according to claim 1, wherein two edges of a respective solar cell of the plurality of solar cells along the second direction are a chamfered edge and a non-chamfered edge, respectively, the chamfered edge of the respective solar cell being adjacent to and being electrically connected to a chamfered edge of an adjacent solar cell by a welding strip, and the non-chamfered edge of the respective solar cell being adjacent to and being electrically connected to a non-chamfered edge of another adjacent solar cell by another welding strip.

6. The back contact solar cell string group according to claim 5, wherein in each of the at least two solar cell strings, two solar cells whose non-chamfered edges are adjacent to each other are electrically connected by m welding strips, m being an even number; and
wherein two solar cells whose chamfered edges are adjacent to each other are electrically connected by n welding strips, n being an odd number, and m - n = 1.

7. The back contact solar cell string group according to claim 6, wherein each of the end welding strips is located between the two solar cells whose non-chamfered edges are adjacent to each other, an extension line of each of the end welding strips passing through chamfered regions of the plurality of solar cells.

8. The back contact solar cell string group according to claim 5, wherein along the second direction, a distance between two solar cells whose chamfered edges are adjacent to each other is greater than a distance between two solar cells whose non-chamfered edges are adjacent to each other.

9. The back contact solar cell string group according to claim 8, wherein along the second direction, the distance between the two solar cells whose chamfered edges are adjacent to each other ranges from 0.3 mm to 1.3 mm; and/or the distance between the two solar cells whose non-chamfered edges are adjacent to each other ranges from 0.1 mm to 1.1 mm.

10. The back contact solar cell string group according to any one of claims 1 to 9, wherein a first polarity connection portion of a respective solar cell of the plurality of solar cells is electrically connected to a second polarity connection portion of an adjacent solar cell by a welding strip, a second polarity connection portion of the respective solar cell being electrically connected to a first polarity connection portion of another adjacent solar cell by another welding strip;
wherein the welding strip connected to the first polarity connection portion of the respective solar cell and the welding strip connected to the second polarity connection portion of the respective solar cell are alternately arranged and spaced away along the first direction, the first polarity connection portion and the second polarity connection portion having opposite polarities.

11. The back contact solar cell string group according to claim 10, wherein the first polarity connection portion and the second polarity connection portion are a P-type doped layer and an N-type doped layer of the respective solar cell, respectively.

12. The back contact solar cell string group according to claim 10, wherein the first polarity connection portion and the second polarity connection portion are a positive gate electrode and a negative gate electrode of the respective solar cell.

13. A photovoltaic module, comprising at least one back contact solar cell string group, wherein each of the at least one back contact solar cell string group is the back contact solar cell string group according to any one of claims 1 to 12.
